# EUROPEAN PATENT APPLICATION

(11) **EP 2 846 365 A1**
(43) Date of publication of application: **11.03.2015**
(21) Application number: 14176474.6
(22) Date of filing: 10.07.2014
(51) Int. Cl.: H01L 33/20

(54) **Light-emitting diodes and fabrication methods thereof**

(30) Priority: 04.09.2013 TW 102131762
(71) Applicant: Lextar Electronics Corporation, Hsinchu 30075 (TW)
(72) Inventor: Tsouo, Po-Hung, 227 New Taipei City (TW); Chou, Tzu-Hung, 320 Zhongli City, Taoyuan County (TW)
(74) Representative: Fuchs Patentanwälte Partnerschaft mbB

(57) **Abstract**

A light-emitting diode is provided. The light-emitting diode includes an N-type epitaxial layer, a light-emitting layer disposed on a portion of the N-type epitaxial layer to expose a partial surface of the N-type epitaxial layer, and a P-type epitaxial layer disposed on the light-emitting layer, wherein the P-type epitaxial layer has a ladder-shaped sidewall. The light-emitting diode further includes a P-type electrode disposed on the P-type epitaxial layer and an N-type electrode disposed on the exposed surface of the N-type epitaxial layer. Furthermore, a method of fabricating a light-emitting diode is also provided. The method includes performing an anisotropicetching process to a P-type epitaxial layer to form a rounded or a right-angled ladder on the sidewall of the P-type epitaxial layer.

## Description

### CROSS REFERENCE TO RELATED APPLICATIONS

This Application claims priority of Taiwan Patent Application No. 102131762, filed on Sep. 4, 2013, the entirety of which is incorporated by reference herein.

### BACKGROUND OF THE INVENTION

### Field of the Invention

The invention relates to light-emitting diodes and more particularly to structures and fabrication methods of light-emitting diodes.

### Description of the Related Art

A light-emitting diode (LED) is a semiconductor electronic component which can provide illumination. The light-emitting diode includes a p-doped semiconductor layer and an n-doped semiconductor layer. When the light-emitting diode is switched on, electrons are able to recombine with holes at the interface between the p-doped semiconductor layer and the n-doped semiconductor layer, releasing energy in the form of photons. This effect is called the electroluminescence of the light-emitting diode. Light-emitting diodes have many advantages over conventional incandescent light bulbs, including lower energy consumption, longer lifespan, smaller size, high brightness, etc. Thus, light-emitting diodes are widely used in applications such as various electronic devices and general lighting.

Generally, the semiconductor materials for forming the light-emitting diode have refractive indexes greater than that of the outside of the light-emitting diode. For example, the refractive indexes of the semiconductor materials are greater than the refractive indexes of packaging materials such as epoxy resin or the refractive index of air. Thus, a total reflection of light occurring at the interface between the semiconductor layers of the light-emitting diode and the outside of the light-emitting diode has a small critical angle. However, conventional light-emitting diode chips are fabricated to have a standard square outward appearance. The four cross-sections of the square outward appearance are parallel with each other, such that the probability of photons leaving the semiconductor layers at the interface between the semiconductor layers and the outside of the light-emitting diode is reduced. Thus, a large portion of light producing by the light-emitting diode is totally reflected from the interface between the semiconductor layers and the outside of the light-emitting diode and back into the interior of the semiconductor layers. Therefore, the luminous efficiency of the conventional light-emitting diodes is poor.

### BRIEF SUMMARY OF THE INVENTION

The disclosure provides structure designs and fabrication methods of light-emitting diodes. The light-emitting diodes have a P-type epitaxial layer with a ladder-shaped sidewall. A rounded or a right-angled ladder-shaped sidewall can be formed on the P-type epitaxial layer by forming a photoresist pattern on the P-type epitaxial layer and performing an anisotropic-etching process to form the P-type epitaxial layer. The ladder-shaped sidewall of the P-type epitaxial layer can reduce a total reflection occurring at the interface between the P-type epitaxial layer and the outside of the light-emitting diode. Thus, the light extraction efficiency of the light-emitting diode is thereby improved and the luminous efficiency of the light-emitting diode is further enhanced.

In embodiments of the disclosure, a light-emitting diode is provided. The light-emitting diode includes an N-type epitaxial layer. A light-emitting layer is disposed on a portion of the N-type epitaxial layer to expose a partial surface of the N-type epitaxial layer. A P-type epitaxial layer is disposed on the light-emitting layer and the P-type epitaxial layer has a ladder-shaped sidewall. A P-type electrode is disposed on the P-type epitaxial layer and an N-type electrode is disposed on the exposed surface of the N-type epitaxial layer.

In embodiments of the disclosure, furthermore, a method of fabricating a light-emitting diode is provided. The method includes providing an N-type epitaxial layer; forming a light-emitting layer on the N-type epitaxial layer; forming a P-type epitaxial layer on the light-emitting layer; forming a first photoresist pattern on the P-type epitaxial layer to expose a portion of the P-type epitaxial layer; and performing an anisotropic-etching process to form a rounded or a right-angled first ladder at an edge of the P-type epitaxial layer.

A detailed description is given in the following embodiments with reference to the accompanying drawings.

### BRIEF DESCRIPTION OF DRAWINGS

The invention can be more fully understood by reading the subsequent detailed description and examples with references made to the accompanying drawings, wherein:
Fig. 1 shows a schematic cross section of a light-emitting diode according to an embodiment of the disclosure;
Fig. 2 is a schematic diagram of a light emission mode at a circle area A of Fig. 1;
Fig. 3 shows a schematic cross section of a light-emitting diode according to an embodiment of the disclosure;
Fig. 4 is a schematic diagram of a light emission mode at a circle area C of Fig. 3; and
Figs. 5A-5F show schematic cross sections of several intermediate stages of fabricating the light-emitting diode of Fig. 1 according to an embodiment of the disclosure.

### DETAILED DESCRIPTION OF INVENTION

The following description is of the best-contemplated mode of carrying out the invention. This description is made for the purpose of illustrating the general principles of the invention and should not be taken in a limiting sense. The scope of the invention is best determined by reference to the appended claims.

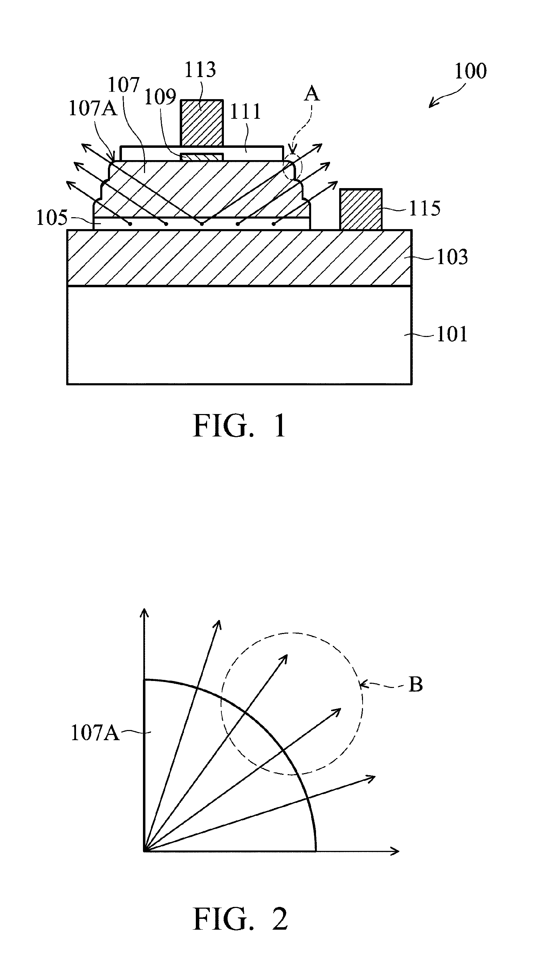

Referring to Fig. 1, a cross section of a light-emitting diode 100 according to an embodiment of the disclosure is shown. The light-emitting diode 100 includes a substrate 101 and an N-type epitaxial layer 103 formed on the substrate 101. A light-emitting layer 105 is formed on a portion of the N-type epitaxial layer 103 to expose a partial surface of the N-type epitaxial layer 103. A P-type epitaxial layer 107 is formed on the light-emitting layer 105 and the P-type epitaxial layer 107 has a ladder-shaped sidewall 107A. In the embodiment, the ladder-shaped sidewall 107A is made up of three rounded ladders. As shown in Fig. 1, the ladder-shaped sidewall 107A has three ladders. However, the number of ladders of the ladder-shaped sidewall 107A is not limited to three. In other embodiments, the ladder-shaped sidewall 107A can have two or more than three ladders.

In addition, the light-emitting diode 100 includes a current blocking layer 109 formed on the P-type epitaxial layer 107. Furthermore, a transparent conductive film 110 is formed on the current blocking layer 109 and covers the P-type epitaxial layer 107. Moreover, the light-emitting diode 100 further includes a P-type electrode 113 formed on the transparent conductive film 110 above the P-type epitaxial layer 107. The light-emitting diode 100 further includes an N-type electrode 115 formed on the exposed partial surface of the N-type epitaxial layer 103. As shown in Fig. 1, the current blocking layer 109 is disposed between the transparent conductive film 110 and the P-type epitaxial layer 107. Furthermore, the current blocking layer 109 is correspondingly disposed under the P-type electrode 113. The transparent conductive film 110 is disposed between the P-type epitaxial layer 107 and the P-type electrode 113.

In an embodiment, the light-emitting diode 100 is for example a blue light-emitting diode, in which the substrate 101 can be a sapphire substrate. The material of the N-type epitaxial layer 103 can be an N-type gallium nitride (N-GaN). The material of the P-type epitaxial layer 107 can be a P-type gallium nitride (P-GaN). In other embodiments, the substrate 101, the N-type epitaxial layer 103 and the P-type epitaxial layer 107 of the light-emitting diode 100 can be formed from other suitable materials, thus various colors of light-emitting diodes are obtained.

In an embodiment, the material of the current blocking layer 109 can be an organic or an inorganic insulating material, such as silicon dioxide. The material of the transparent conductive film 110 is, for example, indium tin oxide or other suitable transparent conductive materials. The transparent conductive film 110 can be used as a current spreading layer, such that a current applying onto the P-type electrode 113 can uniformly spread to the P-type epitaxial layer 107. It can prevent the current from crowding and avoid a high-voltage issue. In addition, the P-type electrode 113 and the N-type electrode 115 can be formed from metal materials. Moreover, the light-emitting diode 100 can further include other element layers, such as a buffer layer disposed between the substrate 101 and the N-type epitaxial layer 103. The structure as shown in Fig.1 is for the sake of simplifying, a structure of the light-emitting diode 100 is not limited to the structure as shown in Fig.1.

According to an embodiment of the disclosure, the P-type epitaxial layer 107 of the light-emitting diode 100 can have a rounded ladder-shaped sidewall 107A. As shown in Fig. 1, the rounded ladder-shaped sidewall 107A can guide a lateral-light emitting from the light-emitting diode 100 to an axial-light emission. Therefore, the luminous efficiency of the light-emitting diode 100 is enhanced. Fig. 2 shows a schematic diagram of a light emitting from the light-emitting diode 100 and passing through the circle area A of Fig. 1. As shown in Fig. 2, the rounded structure of the rounded ladder-shaped sidewall 107A can reduce the probability of a light total reflection to achieve a minimum thereof. A light-emitting scope of the light emitting from the light-emitting diode 100 is thereby broadened. In the circle area B as shown in Fig. 2, light is still emitting. Thus, the light extraction efficiency of the light-emitting diode 100 is effectively enhanced through the structure design of the rounded ladder-shaped sidewall 107A for the P-type epitaxial layer 107.

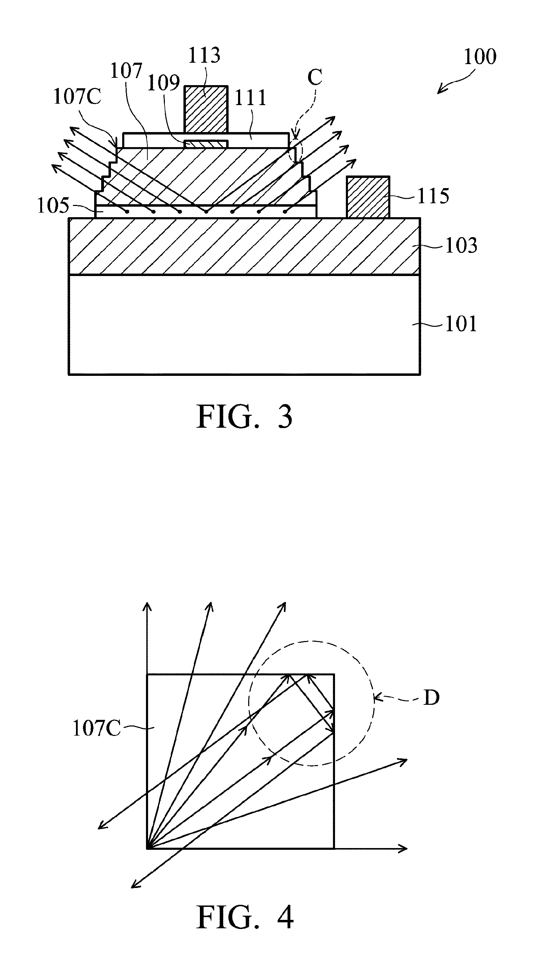

Referring to Fig. 3, a cross section of a light-emitting diode 100 according to an embodiment of the disclosure is shown. The difference between Fig. 3 and Fig. 1 is that a P-type epitaxial layer 107 of the light-emitting diode 100 of Fig. 3 has a right-angled ladder-shaped sidewall 107C. The right-angled ladder-shaped sidewall 107C as shown in Fig. 3 is made up of four ladders. However, the number of ladders of the right-angled ladder-shaped sidewall 107C is not limited to four. In other embodiments, the right-angled ladder-shaped sidewall 107C can have two, three or more than four ladders.

Fig. 4 shows a schematic diagram of a light go forward mode for a light emitting from the light-emitting diode 100 and passing through the circle area C of Fig. 3. When light passes through a right-angled area of the right-angled ladder-shaped sidewall 107C, such as the area D as shown in Fig.4, a total reflection of the light occurs therein. Therefore, a light-emitting scope of the right-angled ladder-shaped sidewall 107C as shown in Fig. 3 is smaller than a light-emitting scope of the rounded ladder-shaped sidewall 107A as shown in Fig. 1. However, compared with a light-emitting diode having no ladder shape formed on a sidewall of a P-type epitaxial layer, but having a square structure for the P-type epitaxial layer, the right-angled ladder-shaped sidewall 107C as shown in Fig. 3 can still reduce the probability of making a total reflection of the light and increase a light-emitting scope of the light. The light extraction efficiency of the light-emitting diode 100 is thereby enhanced.

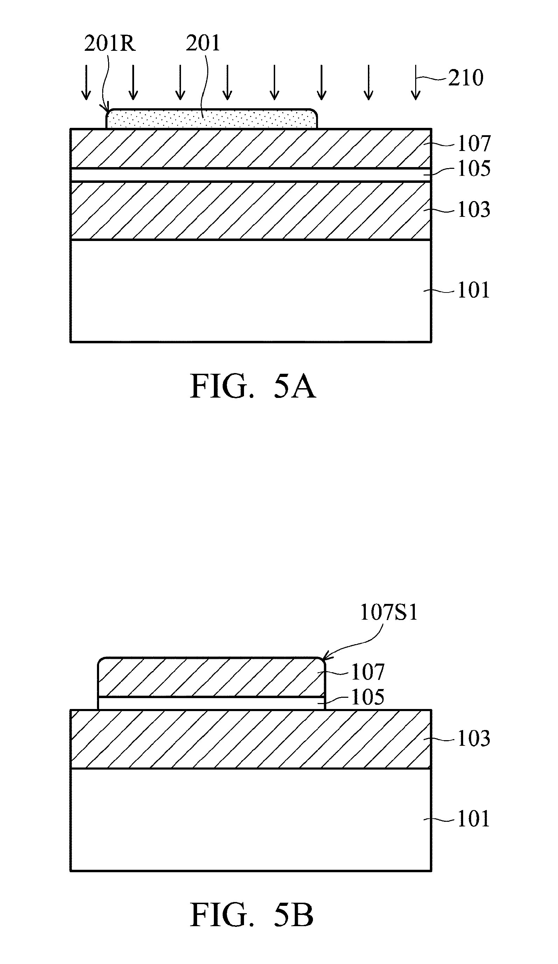

Referring to Figs. 5A-5F, cross sections of several intermediate stages of fabricating the light-emitting diode 100 of Fig. 1 according to an embodiment of the disclosure are shown. Referring to Fig. 5A, firstly, an N-type epitaxial layer 103, a light-emitting layer 105 and a P-type epitaxial layer 107 are grown on a substrate 101 in sequence. Then, a first photoresist pattern 201 is formed on the P-type epitaxial layer 107 to expose a portion of the P-type epitaxial layer 107.

In an embodiment, the first photoresist pattern 201 is a photoresist pattern with a rounded corner 201R at an edge thereof. The rounded corner 201R at the edge of the first photoresist pattern 201 can be formed by a photoresist reflow method to shape the corner thereof. Moreover, the first photoresist pattern 201 can be formed by using a photo-mask for fabricating a mesa structure of the P-type epitaxial layer. Therefore, it can reduce the fabrication cost of one photo-mask.

Next, a first anisotropic-etching process 210, for example an inductively coupled plasma reactive ion etching (ICP-RIE) process, is performed on the P-type epitaxial layer 107. As shown in Fig. 5B, the rounded corner 201R at the edge of the first anisotropic-etching process 210 can be transferred to and printed on the P-type epitaxial layer 107 by performing the anisotropic-etching process 210 to etch the P-type epitaxial layer 107. Thus, a rounded first ladder 107S1 is formed at the edge of the etched P-type epitaxial layer 107. At the same time, the light-emitting layer 105 is also etched to expose a partial surface of the N-type epitaxial layer 103.

In an embodiment, after the anisotropic-etching process 210 is completed, the first photoresist pattern 201 having the rounded corner 201R at the edge thereof can be completely removed by etching. Thus, the rounded corner 201R at the edge of the first photoresist pattern 201 is transferred to and printed on the P-type epitaxial layer 107 by etching to form the rounded first ladder 107S1. In another embodiment, after the anisotropic-etching process 210 is completed, the first photoresist pattern 201 having the rounded corner 201R at the edge thereof can remain on the P-type epitaxial layer 107. Thus, a right-angled first ladder is formed at the edge of the etched P-type epitaxial layer 107. After the anisotropic-etching process 210 is completed, whether the first photoresist pattern 201 is completely removed by etching or remains on the P-type epitaxial layer 107 is determined by an original thickness of the first photoresist pattern 201.

Moreover, in other embodiments, the first photoresist pattern 201 can be a photoresist pattern with a right-angled corner at an edge thereof (not shown). When a photoresist is processed by an exposure and a development, and then the photoresist is not processed with a photoresist reflow treatment, a photoresist pattern having a right-angled corner at an edge thereof is thereby formed. Next, the anisotropic-etching process 210 is performed on the P-type epitaxial layer 107 to form a right-angled first ladder at the edge of the etched P-type epitaxial layer 107.

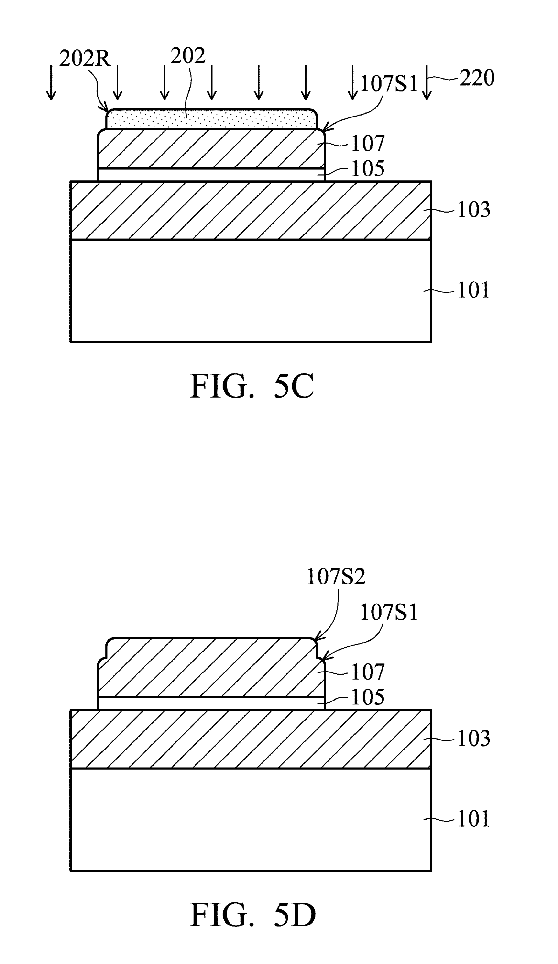

Referring to Fig. 5C, a second photoresist pattern 202 is formed on the P-type epitaxial layer 107 having the rounded first ladder 107S1 at the edge thereof. Moreover, the side surface and the upper surface of the first ladder 107S1 are exposed. In an embodiment, the second photoresist pattern 202 is a photoresist pattern with a rounded corner 202R at an edge thereof.

Next, a second anisotropic-etching process 220, for example an inductively coupled plasma reactive ion etching (ICP-RIE) process, is performed on the P-type epitaxial layer 107. As shown in Fig. 5D, the rounded corner 202R at the edge of the second photoresist pattern 202 can be transferred to and printed on the P-type epitaxial layer 107 by performing the anisotropic-etching process 220 to etch the P-type epitaxial layer 107. Then, a rounded second ladder 107S2 is formed at the edge of the second etched P-type epitaxial layer 107 and adjacent to the first ladder 107S1. Now, the sidewall of the P-type epitaxial layer 107 has two rounded ladders 107S1 and 107S2 formed thereon.

In an embodiment, the second photoresist pattern 202 can be formed by using a photo-mask for fabricating a current blocking layer. Therefore, it can further save the fabrication cost of one photo-mask. If the second photoresist pattern 202 is formed by using the photo-mask for fabricating the current blocking layer, the second photoresist pattern 202 will have an opening (not shown) formed at a location corresponding to the current blocking layer to expose the P-type epitaxial layer 107. Therefore, after the second anisotropic-etching process 220 is performed, a depression (not shown) is formed on an upper surface of the P-type epitaxial layer 107 at the location corresponding to the current blocking layer.

The step of forming a photoresist pattern and the step of performing an anisotropic-etching process over the P-type epitaxial layer 107 are repeated several times. Then, a plurality of rounded or right-angled ladders is formed on the sidewall of the P-type epitaxial layer 107. The thickness of the photoresist patterns in each step can be determined by the thickness of the P-type epitaxial layer 107 and a predetermined amount of ladders formed on the sidewall of the P-type epitaxial layer 107. Generally, if the thicknesses of the photoresist patterns in each step are the same, the thickness of the photoresist pattern in each step is almost equal to the thickness of the P-type epitaxial layer 107 divided by the number of ladders formed on the sidewall of the P-type epitaxial layer 107.

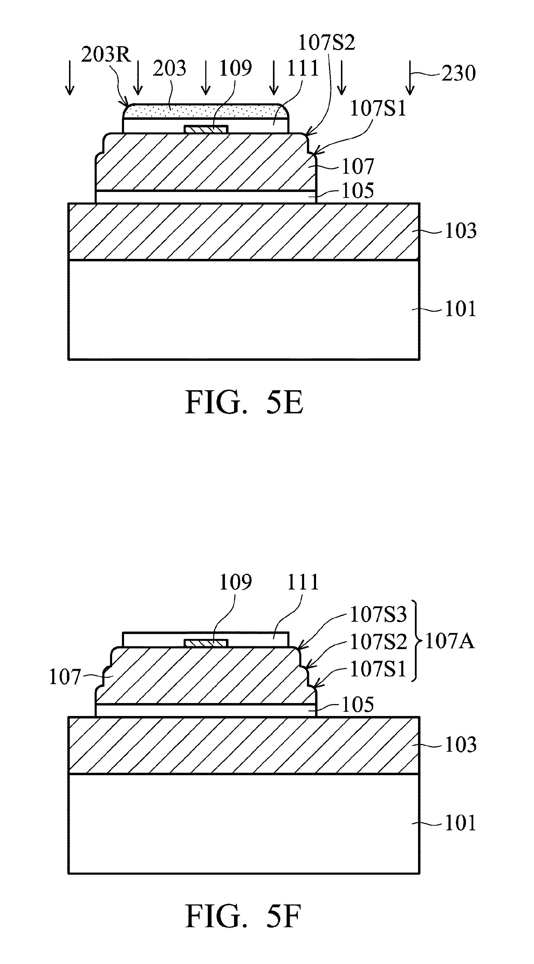

As shown in Fig. 5E, a current blocking layer 109 is formed on the upper surface of the P-type epitaxial layer 107 which has the first ladder 107S1 and the second ladder 107S2 formed on the sidewall thereof. Then, a transparent conductive film 111 is formed to cover the current blocking layer 109 and the P-type epitaxial layer 107. Next, a third photoresist pattern 203 with a rounded corner 203R at an edge thereof is formed on the transparent conductive film 111. Moreover, the side surface and the upper surface of the second ladder 107S2 are exposed. In an embodiment, the third photoresist pattern 203 can be formed by using a photo-mask for fabricating the transparent conductive film 111. Therefore, it can further reduce the fabrication cost of one photo-mask.

Next, a third anisotropic-etching process 230, for example an inductively coupled plasma reactive ion etching (ICP-RIE) process, is performed on the P-type epitaxial layer 107. As shown in Fig. 5F, the rounded corner 203R at the edge of the third photoresist pattern 203 can be transferred to and printed on the P-type epitaxial layer 107 by performing the anisotropic-etching process 230 to etch the P-type epitaxial layer 107. Then, a rounded third ladder 107S3 is formed at the edge of the third etched P-type epitaxial layer 107 and adjacent to the second ladder 107S2. Thus, the sidewall of the P-type epitaxial layer 107 has three rounded ladders 107S1, 107S2 and 107S3 formed thereon. The fabrication of the ladder-shaped sidewall 107A of the P-type epitaxial layer 107 as shown in Fig. 1 is completed.

Next, a P-type electrode 113 is formed on the transparent conductive film 111. An N-type electrode 115 is formed on the exposed surface of the N-type epitaxial layer 103. Then, the fabrication of the light-emitting diode 100 of Fig. 1 is completed.

In other embodiments, the current blocking layer 109 and the transparent conductive film 111 can be formed after the fabrication of the ladder-shaped sidewall of the P-type epitaxial layer 107 is completed.

According to the embodiments of the disclosure, by performing the step of forming the photoresist pattern with a rounded or a right-angled corner at the edge thereof and the step of performing an anisotropic-etching process over the P-type epitaxial layer several times, a plurality of rounded or right-angled ladders can be formed on the sidewall of the P-type epitaxial layer of the light-emitting diode. The ladder-shaped sidewall of the P-type epitaxial layer can reduce the probability of a total reflection of light produced at the interface between the P-type epitaxial layer and the outside of the light-emitting diode. Therefore, the light extraction efficiency of the light-emitting diode is improved and the luminous efficiency of the light-emitting diode is further enhanced.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A light-emitting diode (100), comprising:
an N-type epitaxial layer (103);
a light-emitting layer (105) disposed on a portion of the N-type epitaxial layer to expose a partial surface of the N-type epitaxial layer;
a P-type epitaxial layer (107) disposed on the light-emitting layer and the P-type epitaxial layer has a ladder-shaped sidewall (107A, 107C);
a P-type electrode (113) disposed on the P-type epitaxial layer; and
an N-type electrode (115) disposed on the exposed partial surface of the N-type epitaxial layer.

2. The light-emitting diode as claimed in claim 1, wherein the ladder-shaped sidewall includes a plurality of right-angled ladders (107C).

3. The light-emitting diode as claimed in claim 1, wherein the ladder-shaped sidewall includes a plurality of rounded ladders (107A).

4. The light-emitting diode as claimed in any one of claims 1 to 3, further comprising a transparent conductive film (111) disposed between the P-type epitaxial layer and the P-type electrode.

5. The light-emitting diode as claimed in any one of claims 1 to 4, further comprising a current blocking layer (109) disposed between the transparent conductive film and the P-type epitaxial layer and disposed on the P-type epitaxial layer under the P-type electrode.

6. A method of fabricating a light-emitting diode (100), comprising:
providing an N-type epitaxial layer (103);
forming a light-emitting layer (105) on the N-type epitaxial layer;
forming a P-type epitaxial layer (107) on the light-emitting layer;
forming a first photoresist pattern (201) on the P-type epitaxial layer to expose a portion of the P-type epitaxial layer; and
performing an anisotropic-etching process (210) to form a rounded or a right-angled first ladder (107S1) at an edge of the P-type epitaxial layer.

7. The method as claimed in claim 6, wherein the anisotropic-etching process comprises an inductively coupled plasma reactive ion etching process.

8. The method as claimed in any one of claims 6 to 7, further comprising:
forming a second photoresist pattern (202), with a rounded corner (202R) at an edge of the second photoresist pattern, on a surface of the P-type epitaxial layer to expose a side surface and an upper surface of the first ladder; and
performing an anisotropic-etching process (220) to form a rounded second ladder (107S2) adjacent to the first ladder.

9. The method as claimed in claim 8, wherein the anisotropic-etching process comprises an inductively coupled plasma reactive ion etching process.

10. The method as claimed in any one of claims 6 to 9, further comprising:
forming a transparent conductive film (111) on the P-type epitaxial layer having the first and the second ladders; and
forming a P-type electrode (113) on the transparent conductive film and an N-type electrode (115) on the N-type epitaxial layer.

11. The method as claimed in any one of claims 6 to 10, further comprising forming a current blocking layer (109) between the transparent conductive film and the P-type epitaxial layer and on the P-type epitaxial layer under the P-type electrode.
